# EUROPEAN PATENT SPECIFICATION

(11) **EP 3 514 515 B1**
(45) Date of publication and mention of the grant of the patent: **04.03.2020**
(21) Application number: 18152264.0
(22) Date of filing: 18.01.2018
(51) Int. Cl.: G01K 1/14, G01K 7/04

(54) **THERMOCOUPLE AND METHOD FOR MANUFACTURING THE THERMOCOUPLE**
THERMOELEMENT UND VERFAHREN ZUR HERSTELLUNG DES THERMOELEMENTS
THERMOCOUPLE ET PROCÉDÉ DE FABRICATION DE LA THERMOCOUPLE

(43) Date of publication of application: 24.07.2019
(73) Proprietor: Samsung SDI Co., Ltd., Yongin-si, Gyeonggi-do 17084 (KR)
(72) Inventor: Schiffer, Adrian, 1050 Wien (AT)
(74) Representative: Gulde & Partner

(56) References cited:
- GB-A- 2 128 743
- US-A- 4 338 479
- US-A1- 2010 172 392

## Description

### Field of the Invention

The present invention relates to a thermocouple, particularly to a modified thermocouple configured for being ball-bonded or wedge-bonded to a target surface by a wire-bonding apparatus. The invention further relates to a method for manufacturing such thermocouple and to a method of bonding, particularly ball-bonding or wedge-bonding, such thermocouple to a target surface. The invention further relates to the use of a modified bonding tool for bonding the thermocouple of the invention to a target surface as well as to a battery module comprising the thermocouple according to the present invention.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

Battery modules can be constructed either in block design or in modular design. In block design, each battery cell is coupled to a common current collector structure and a common battery management system. In modular designs, pluralities of battery cells are connected to form submodules and several submodules are connected to form the battery module. Battery management functions may be realized either on module or submodule level and thus interchangeability of the components is improved. One or more battery modules are mechanically and electrically integrated, equipped with a thermal management system and set up for communication with electrical consumers in order to form a battery system.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers. Battery systems usually comprise a battery management system (BMS) for processing this information.

One significant parameter related to the state of a battery cell or module is the battery cell (module) temperature. Therefore, temperature sensitive elements (sensors) are provided within the battery module and the signals provided by such sensors are then considered in controlling the battery module and/or in controlling a thermal management system. A variety of temperature sensors providing an electronic temperature dependent signal, such as e.g. thermistor-based or thermocouple-based temperature sensors, can be used in battery modules. Utilized temperature sensors usually comprise a measurement probe that has to be brought into thermal contact with a target surface of a battery cell and/or module. Therefore spring-loaded measurement probes, e.g. for PTC-based sensors, or thermowells, e.g. for thermocouple-based sensors have been used. The thermowells-based solutions for thermocouples may lead to slow temperature sensing due to a delayed heat transfer.

The structure of a thermocouple usually depends on the temperature range to be sensed and the environmental conditions the thermocouple is exposed to. In industrial applications often sheathed thermocouple are used, where the wires are embedded in ceramic insulation with a stainless steel or nickel alloy sheath enclosing the ceramic matrix. Sheathed thermocouples can be brought in contact with a target surface by using a thermowells or, if the measuring junction is ungrounded, by welding the sheath material to the target surface. Further, weldable connectors exist for bringing thermocouples in thermal contact with a target surface. Prior art with respect to thermally connecting a thermocouple's measuring junction to a target surface are described in US 4,659,898, US 3,939,554, US 5,141,335, US 5,141,335, and GB 2 128 743.

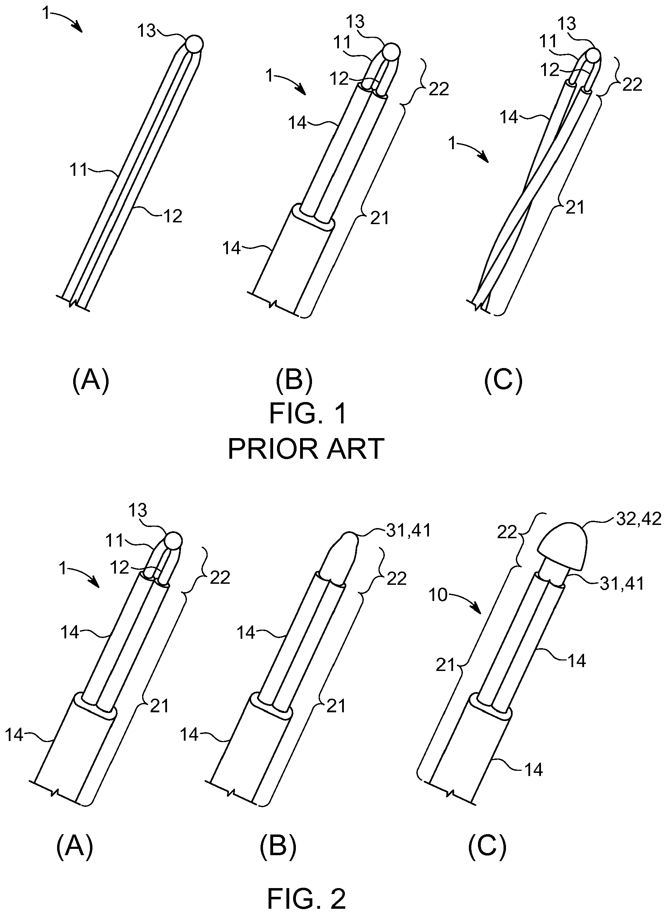

However, the sheathed thermocouples usually applied in industrial applications are rather rigid, such that the connections, particularly welding connections, to the target surface are prone to damages and detachment of the target surface. This may have an adverse effect of the thermal measurements obtained by the thermocouple, which are strongly correlated to the quality of the junction's bond to the target. In automotive applications, where strong vibrations and impacts are likely to occur during the operation of the thermocouple, it is thus desired to use more elastic thermocouples. A suitable option cold be basic thermocouples as illustrated in Figure 1 that consist mainly of an elastic wire pair with an exposed junction. However, so far these basic thermocouples had to be soldered by hand to the target surface and their application was thus mainly restricted to science or to prototype construction.

It is thus an object of the present invention to overcome or reduce at least some of the drawbacks of the prior art and to provide an improved thermocouple and a bonding method for such improved thermocouple that can be used on an industrial scale and allows for a long-term stable connection to a target surface even under prolonged vibrations and impacts.

### Description of Invention

One or more of the drawbacks of the prior art could be avoided or at least reduced by means of the present invention. According to a first aspect of the present invention, a thermocouple for temperature measurements is provided that comprises a first wire of a first metallic material and a second wire of a second metallic material different from the first metallic material. The thermocouple comprises a first section and a second section in a lengthwise direction of the thermocouple. The first section of the thermocouple is configured to bend elastically, preferably across the whole length of the first section. Further, in the first section, the first and second wire run electrically isolated from each other. In the second section of the thermocouple the first wire and the second wire are connected to each other to form a measuring junction. The connection may be a welded connection but other connection types are possible as well, the wires may even be twisted.

A first layer of a thermally conductive and electrically isolating first material encloses at least a part of the second section. Preferably, the first layer of the first material surrounds (coats) at least the measuring junction, and particularly preferred the first material coats the full second section of the thermocouple. Further, a second layer of ultrasonic-weldable second material encloses at least a part of the first layer. The second layer is configured to be ultrasonic welded to a target surface. Preferably, the second material coats at least the whole embedded measuring junction and is, further preferred, different from the first material.

The thermocouple of the present invention can advantageously be used in a modified wire-bonding apparatus. Therein, a weld connection between the thermocouple and a target surface can be established via ultrasonic welding the second material to the target surface using the wire-bonding apparatus. In the weld, the first layer of first material electrically isolates the measuring junction from the second material and the target surface. Preferably standard wire-bonding apparatuses can be used for bonding the thermocouple to the target surface with only minor modifications carried out to a capillary tool of such apparatus and by replacing a wire coil of the apparatus by a magazine for hosting at least one thermocouple.

Hence, by using a standardized thermocouple of the invention in a modified wire-bonding apparatus a well defined thermal contact can be replicable established between the measuring junction and a target surface. As the quality of the thermal contact strongly influences the measurements of the thermocouple, reliable and comparable measurements can be obtained with the thermocouple of the invention that allows for reproducible bonding.

Further, due to the elasticity of the first section, the thermocouple can be loaded into and applied, guided and positioned by the modified wire-bond apparatus without a risk of breaking its wires or damaging a welded connection. Also, after establishing a weld connection via the second material, the free ends of the first end second wire can be welded to respective contact pads via the modified wire-bonding machine as well. Hence, with the thermocouple of the invention a fully automated setup of a thermocouple temperature sensor is achievable.

Further preferred, a basic elastic thermocouple is provided as the starting point for the thermocouple of the invention. Therein, the first section comprises an insulated pair of different wires, insulated e.g. with standard plastic cable insulations, and the second section comprises an exposed section of the pair of wires, wherein the wires are connected, e.g. welded, to each other to form a measuring junction. Such basic elastic thermocouples are freely available for commercial applications. The thermocouple of the present invention is then obtained by coating exclusively the second section of the basic thermocouple with the first material and, subsequently, with the second material. As such basic thermocouples are inexpensive; the thermocouple of the invention can be manufactured in a cost-effective way, which further benefits the mass production of the thermocouple according to the invention.

Preferably, the first and second wire of the thermocouple form one of a nickel-alloy thermocouple (Type E, J, K, M, N, or T), a platinum/rhodium-alloy thermocouple (Type B, R, or S), a tungsten/rhenium-alloy thermocouple (Type C, D, G), a chromel-gold/iron-alloy thermocouple, a noble-metal alloy thermocouple /Type P), a platinum/molybdenum-alloy thermocouple, a iridium/rhodium alloy thermocouples, a pure noble-metal (Au-Pt, Pt-Pd) thermocouple, or a skutterudite thermocouple. A suitable thermocouple is preferably chosen in dependence of the temperature range of interest and, with respect to the coating of the first and second material, with respect to material parameters of the first and second material.

Preferably, the length of the first section exceeds the length of the second section in a lengthwise direction of the thermocouple. Particularly preferred the length of the first section is at least 5 times, 10 times, 15 times, 20, or even 25 times the length of the second section. Therewith a sufficient elasticity of the overall thermocouple is provided and the applicability of the thermocouple of the invention using a modified wire-bonding apparatus is ensured.

Further preferred, a layer thickness of the first layer is between 0,5 mm and 5 mm, preferably between 0.1 mm and 3 mm, and particularly preferred between 0.1 mm and 1 mm. Such preferred layer thickness enables electric insulation of the measuring junction without significantly decreasing thermal conduction between measuring junction and target surface.

Further preferred, a layer thickness of the second layer is between 50 µm and 1 mm, preferably between 50 µm and 500 µm, and particularly preferred between 100 µm and 500 µm. Such preferred layer thickness is advantageously sufficient for manufacturing a reliable and replicable weld connection, e.g. a wedge bond or a ball bond, between the measuring junction and the target surface using a modified wire-bonding apparatus. The low layer thickness of the second layer further contributes to a cost-effective production process.

Both of the first wire and the second wire preferably have an overall diameter between 150 µm and 3.5 mm, preferably between 300 µm and 2 mm, and particularly preferred between 500 µm and 1 mm, respectively. Further preferred, the thermocouple has an overall diameter between 300 µm and 14 mm, particularly preferred between 400 µm and 10 mm, and further preferred between 500 µm and 3 mm. As the wires and the thermocouple do not necessarily have a circular cross section, the overall diameter refers to the largest linear extension of cross sections deviating from a circle. Low overall diameters of the wires and of the thermocouple allow for the use of wire-bonding apparatuses that are widely available for commercial applications and with the need for only minimal modifications applied thereto.

According to a particularly preferred embodiment, the first material is a plastic material and, particularly preferred, at least one of polyethylene, polyimide, polyamide, polybutylene terephthalate, polypropylene, polyether ether ketone, epoxy resin or polyphenylene sulfide. These materials provide sufficient electric insulation and at the same time satisfactory thermal conductivity. Further, these materials can be provided in a variety of solid states and hence allow for an uncomplicated application process. Polyimide is particularly preferred due to its thermal stability in a wide temperature range and its good thermal conductivity. Further preferred, the first material comprises thermally conductive fillers, such as e.g. graphite, carbon, sapphire, metal, or ceramic particles. According to an alternatively preferred embodiment, the first material is a ceramic compound with a high thermal stability. Particularly preferred the first material is magnesium oxide. The use of a temperature stable ceramic compound as first material allows for applying the second material from a melt.

Further preferred, the second material comprises an alloy of at least one of gold, copper, and aluminum. These materials are standard materials for wire-bonding applications and thus provide high reliability in providing a weld connection by ultrasonic welding using a modified wire-bonding apparatus. However, also other materials, such as plastic materials, can be principally used, as long as they are ultrasonic weldable and provide sufficient thermal conductivity. Further preferred, the second material is adapted, e.g. equal, to the material of a target surface in order to provide an improved substance to substance bond via the weld.

In a further preferred embodiment, the first wire and the second wire of the thermocouple have different length. Hence, the thermocouple has a basic Y-shape with different lengths of the two top legs. A measuring junction is provided by connecting a first free end of the first wire and a first free end of the second wire, e.g. via a weld connection. By providing the first and second wire with different lengths, the remaining second free ends of the first wire and second wire can be separately attached to respective contact pads of a circuit carrier with a modified wire-bonding apparatus in a consecutive manner, e.g. with a ball or wedge bond.

According to a particularly preferred embodiment, the first material is a plastic material and, particularly preferred, at least one of polyethylene, polyimide, polyamide, polybutylene terephthalate, polypropylene, polyether ether ketone, epoxy resin or polyphenylene sulfide. In such preferred embodiment of the method, the second section is then preferably embedded in the first layer of the first material by immersing the second section in a melt or solution of the first material. Particularly preferred, exclusively the second section, or exclusively the measuring junction, of the basic thermocouple is immersed in the melt or the solution of the first material. After pulling the second section or the measuring junction out of the solution or melt, the first layer of the first material forms due to evaporating of a solvent or due to solidification of the adhered melt. Preferably, the plastic material is polyimide and also preferred the melt or solution of the first material comprises a thermally conductive filler.

Subsequently to forming the first layer of the first material according to such preferred embodiment, at least part of the first layer is embedded in the second material by wrapping a thin foil of the second material around a tip of the second section. Therein, the thin foil of the second material is preferably provided with a thickness between 50 µm and 1 mm, particularly preferred between 50 µm and 500 µm, and further preferred between 100 µm and 500 µm. Further preferred, the thin foil is provided with a surface area corresponding at least roughly to the surface area of the second section embedded in the first material. Therein, the surface area of the thin foil refers to the surface area of a single side of the foil. The wrapping of the foil around the embedded second section or measuring junction may be performed by movably holding an edge section of the thin foil and by guiding the tip of the embedded second section or measuring junction towards and into the foil such that the foil lays around the second section. Essentially this might be considered as a microscopic version of a deep drawing process. Alternatively, a wrapping tool as utilized in packaging machines of the food industry can be applied to wrap the thin foil around the second section.

According to an alternatively preferred embodiment of the present method, the first material is a ceramic compound with high thermal stability. Particularly preferred the first material is magnesium oxide. Then the method preferably comprises the steps of inserting a ceramic compound powder, e.g. magnesium oxide powder, and the second section into a mold. Therein, the ceramic compound powder may have been grounded beforehand to a grain size and grain form that are suitable for allowing to solidify the ceramic compound powder by compactification. In a further step, the ceramic compound powder is compression molded around the second section, preferably by closing the mold and by applying pressure to the ceramic compound powder such that it compacts around the second section of the thermocouple. The compacted ceramic compound powder should be form stable at least temporarily after the compression molding in order to allow application of the second layer.

Due to the high temperature stability of ceramic compounds, particularly magnesium oxide, in a preferred embodiment of the method, at least a part of the second section coated by the first layer is then embedded in the second material by immersing at least a part of the coated second section, e.g. the coated embedded measuring junction, in a melt of the second material, preferably in a melt of an alloy of at least one of gold, copper, and aluminum. If the second material solidifies it safely encloses the first material compacted ceramic powder.

Another aspect of the present invention relates to a method for bonding a thermocouple to a target surface. Particularly preferred, the target surface is part of at least one battery cell or battery cell casing of a battery module and the bonding method is integrated into a method for manufacturing a battery module. The bonding method of the invention comprises the steps of:
- inserting at least one thermocouple according to the invention as described above into a magazine of a wire-bonding apparatus;
- loading one thermocouple from the magazine into a capillary tool of the wire-bonding apparatus;
- applying downward pressure and ultrasonic energy to the embedded second section of the thermocouple via the capillary tool; and
- welding the second material of the embedded second section to the target surface.

The bonding method of the present invention is advantageously performed with a wire-bonding apparatus at it is commercially available for microelectronic applications, e.g. for providing wire connections between a chip pad and a lead frame. A wire-bonding apparatus as utilized in the bonding method of the invention is usually configured for producing a ball-bond and/or a wedge-bond between a wire segment and a target surface. With minor modifications applied thereto, the wire-bonding apparatus is configured for producing a ball-bond and/or a wedge bond between a thermocouple of the invention as described above and a target surface. The minor modifications refer at least to the replacement of a wire coil with a magazine configured for hosting at least one thermocouple of the invention and the adaption of a capillary tool of the wire-bonding apparatus to the overall diameter of such thermocouple.

In the bonding method of the invention, a wire-bonding apparatus is equipped with a thermocouple of the invention as described above by providing a suitable magazine. From such magazine, a single thermocouple is loaded to a capillary tool of the wire-bonding apparatus. The capillary tool is then positioned on a target surface and the thermocouple is guided through the capillary tool such that a tip of the second section, i.e. the embedded measuring junction, is aligned with an opening of the capillary tool. The thermocouple is fixated in the capillary tool and the aligned embedded measuring junction is put on the target surface. Subsequently downward pressure is exerted onto the fixed thermocouple via the capillary tool and ultrasonic energy is applied to the thermocouple via an ultrasonic transducer. Thus, the second material coating the second section is ultrasonic welded to the target surface. Hence, a reliable and long term stable mechanical connection having defined thermal properties is produced between the thermocouple and the target surface.

According to a preferred embodiment the bonding method of the present invention further comprises the step of at least partially fusing the second material of the aligned embedded second section by applying heat or an electric arc thereto before applying downward pressure and ultrasonic energy to the thermocouple. According to this embodiment, the second material is at least partially melted before putting the embedded measuring junction on the target surface, such that a ball of fused second material forms at the tip of the second section. This ball of fused second material is then put on the target surface to form a ball-bond. Advantageously, in this embodiment the capillary tool can be freely moved in any direction after producing the ball-bond and hence alignment of the capillary tool is simplified.

According to a further preferred embodiment of the present invention, the second end of the first wire and the second end of the second wire are welded to respective contact pads on a circuit carrier, e.g. on a cell supervision circuit carrier. Therein, after producing the bond between the embedded second section, particularly the embedded measuring junction, and the target surface, the fixation of the thermocouple in the capillary tool is released and the capillary tool is moved to the position of the respective contact pad, wherein the thermocouple is guided through the capillary tool. At the position of the contact pad one of the free second ends of the first wire and second wire is positioned in the opening of the capillary tool and can be bonded to the target surface via a wedge-bond. Particularly preferred, a thermocouple with first and second wires of different length as described above is used in this embodiment. Then, if the capillary tool arrives at the position of a first contact pad, preferably the free second end of one of the first and second wire is positioned in the opening of the capillary tool and, if the capillary tool arrives at the position of a second contact pad, the free second end of the other one of the first and second wire is positioned in the opening. Hence, both of the free second ends of the thermocouple wires can be bonded to a respective contact pad via the wire-bonding apparatus with reduced risk of electrically shorting the wires.

Another aspect of the present invention relates to the use of a modified wire-bonding apparatus for bonding a thermocouple according to the invention as described above to a target surface in a bonding method of the invention as described above. Therein the wire-bonding apparatus is based on a standard wire bonding apparatus that is modified at least in that it comprises a magazine configured for accommodating at least one thermocouple, and a capillary tool configured for loading a thermocouple and for applying downward pressure and ultrasonic energy to the embedded second section of the loaded thermocouple, wherein an inner diameter of the capillary tool is adapted to an outer diameter of the thermocouple.

Prior art wire-bonding apparatuses and capillary tools (bonding capillaries) are known to the person skilled in the art and, as such, are not subject of the present invention. However, such wire-bonding apparatus can be equipped with a thermocouple of the invention as described above by providing a suitable magazine. From there, a single thermocouple can be loaded to a capillary tool of the wire-bonding apparatus. The capillary tool comprises a capillary configured for guiding the thermocouple and at least one element configured for fixing the thermocouple in the capillary in order to exert downward pressure onto the thermocouple. The wire-bonding apparatus further comprises at least one element configured for guiding a thermocouple from the magazine into and through the capillary, at least one element configured for moving and positioning the capillary tool and at least one ultrasonic transducer. Preferably, the capillary tool further comprises at least one element for exerting heat or an electric arc to the opening region of the capillary tool and a thermocouple positioned therein.

Another aspect of the present invention relates to a battery module, comprising a plurality of stacked battery cells that are electrically interconnected in series and/or in parallel between a negative module terminal and a positive module terminal via a plurality of busbars. The battery module further comprises a cell supervision circuit, CSC, carrier that is arranged on top of the plurality of stacked battery cells and that comprises at least one first contact pad and at least one second contact pad. The battery module further comprises at least one thermocouple according to the present invention as described above, wherein the second material of the embedded second section of the at least one thermocouple is welded to a top surface of a battery cell, and wherein a free end of the first wire is welded to a first contact pad and a free end of the second wire is welded to a second contact pad. The CSC carrier preferably comprises at least one cell supervision circuit that is electrically connected to the first and second contact pads and is configured for receiving and processing signals related to the temperatures detected via the thermocouple and, preferably, voltages of the cells.

Further aspects of the present invention could be learned from the dependent claims or the following detailed description of the drawings.

### Brief Description of the Drawings

Features will become apparent to those of ordinary skill in the art by describing in detail exemplary embodiments with reference to the attached drawings in which:
- Fig. 1: (A) to (C) schematically illustrates basic thermocouples according to the prior art;
- Fig. 2: (A) to (C) schematically illustrates a modification of a basic thermocouple according to an embodiment;
- Fig. 3: schematically illustrates a cross section of a second section of a thermocouple according to an embodiment
- Fig. 4: (A) and (B) schematically illustrates a first embodiment of a method for producing a thermocouple according to an embodiment from a basic thermocouple;
- Fig. 5: (A) and (B) schematically illustrates a second embodiment of a method for producing a thermocouple according to an embodiment from a basic thermocouple;
- Fig. 6: (A) to (C) schematically illustrates the bonding a thermocouple according to an embodiment to a target surface using a capillary tool; and

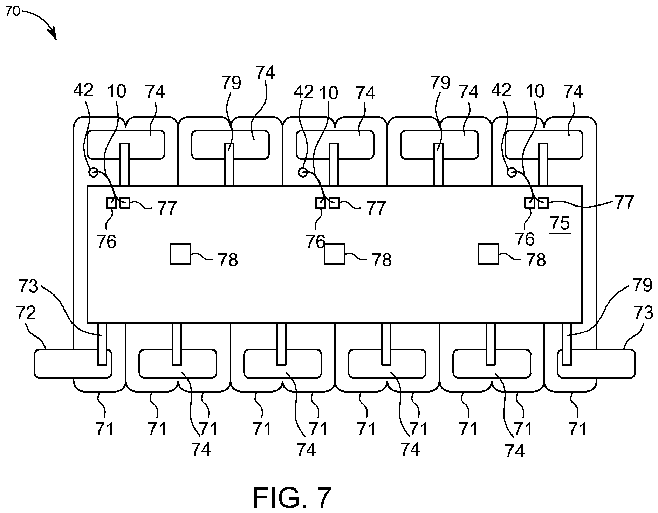

- Fig. 7: schematically illustrates a battery module according to an embodiment.

### Detailed Description of the Drawings

Features of the inventive concept and methods of accomplishing the same may be understood more readily by reference to the following detailed description of embodiments and the accompanying drawings. Hereinafter, example embodiments will be described in more detail with reference to the accompanying drawings, in which like reference numbers refer to like elements throughout. The present invention, however, may be embodied in various different forms, and is not limited to only the illustrated embodiments herein.

Unless otherwise noted, like reference numerals denote like elements throughout the attached drawings and the written description, and thus, descriptions thereof will not be repeated. In the drawings, the relative sizes of features may be exaggerated for clarity.

It will be understood that, although the terms "first," "second," "third," etc., may be used herein to describe various elements, these elements should not be limited by these terms. These terms are used to distinguish one element from another element. Thus, a first element could be termed a second element without departing from the scope of the present invention.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

As used herein, the term "and/or" includes any and all combinations of one or more of the associated listed items. Expressions such as "at least one of," preceding a list of elements, modify the entire list but not its individual elements. As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

Unless otherwise defined, all terms (including technical and scientific terms) used herein have the same meaning as commonly understood by one of ordinary skill in the art to which the present invention belongs. It will be further understood that terms should be interpreted as having a meaning that is consistent with their meaning in the context of the relevant art and/or the present specification, and should not be interpreted in an idealized or overly formal sense.

Figure 1 (A) to (C) shows basic thermocouples 1 according to the prior art that are commercially available particularly for scientific purposes or prototype construction. These basic thermocouples comprise a first wire 11 and a second wire 12 that are bead welded to each other to form a measuring junction 13. The basic thermocouples 1 are configured to bend elastically, i.e. they are not rigid, preferably across their whole length. Further, the basic thermocouples 1 comprise a first section 21, wherein the first 11 and second wire 12 run electrically isolated from each other by being surrounded by at least one plastic cable insulation 14. The basic thermocouples 1 further comprise a second section 22, wherein the measuring junction 13 is formed and wherein the wires 11, 12 are exposed, i.e. not insulated.

Figure 2 (A) to (C) show different stages in a method for producing a thermocouple 10 according to the invention from a basic thermocouple 1. Therein, Figure 2 (A) shows the basic thermocouple 1 of Figure 1 (B) and Figure 2 (C) shows a thermocouple 10 of the invention. The basic thermocouple 1 of Figure 2 (A) is transformed to a thermocouple of the invention 10 by initially coating the second section 22 of the basic thermocouple 1 with a first layer 31 of a first material 41. Therein the first material 41 is thermally conductive and electrically insulating. Then, the first layer 31 of first material 41 is partially coated with a second layer 32 of a second material 42 that is ultrasonic weldable to a target surface.

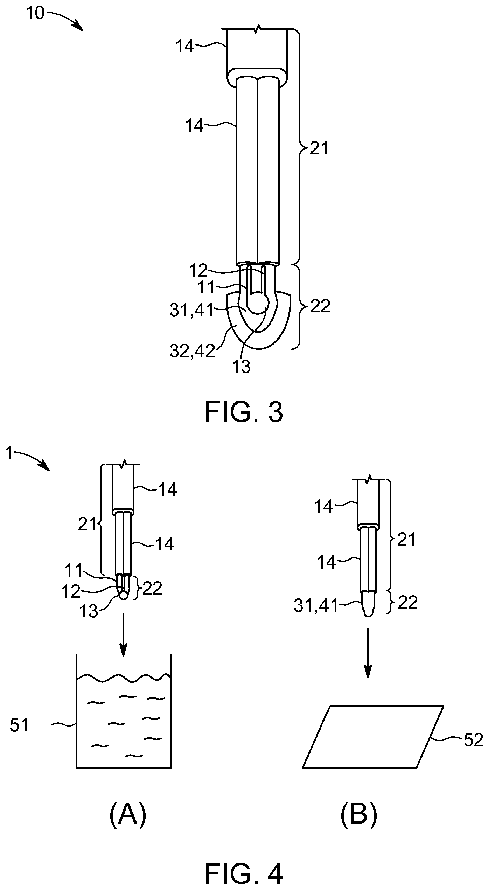

Figure 3 shows the thermocouple 10 according to the invention of Figure 2 (C) with a cross-sectional cut through the second section 22 of the thermocouple 10. In the second section 22, the first wire 11 and the second wire 12 are connected to each other in the measuring junction 13. The measuring junction 13 is embedded (coated) by a first layer 31 of a first material 41 that is electrically insulating the measuring junction 13 but does not impede heat flux to and from the measuring junction 13. The first material 41 might be polyimide and the first layer might have a thickness of 1 mm around the bead-shaped measuring junction 13. The first layer 31 is partially embedded (coated) by a second layer 32 of a second material 42. At least the tip, i.e. the embedded measuring junction 13, is coated by the second layer 32 of the second material 42. Preferably the second material 42 is aluminum and the second layer 32 has a thickness of 100 µm. The thermocouple 10 as illustrated in Figure 3 can be advantageously bonded to a target surface using a wire-bonding apparatus.

Figure 4 schematically illustrates a method for producing a thermocouple 10 of the invention. Therein, in step (A) a basic thermocouple 1 as described above is provided. In the first step (A) of the illustrated method, the second section 22 of the basic thermocouple 1 is immersed in a solution 51 of the first material, particularly in a solution of polyimide in dimethylformamide (DMF), N-methyl pyrrolidon (NMP), or N-ethyl pyrrolidon (NEP) as a solvent. A first layer 31 of polyimide as the first material 41 is thus dip coated onto the second section 22 of the basic thermocouple 1. After the solvent has evaporated and the polyimide coating is cured, the method proceeds with a second step (B). Therein, a thin aluminum foil 52 is provided with a thickness of 100 µm and a one sided surface area that is essentially equal to 50 % of the surface area of the second section 22 coated in the first material 41. As indicated by the arrow in Figure 4 (B) the thermocouple 10 is moved such that the second section 22 is driven into the thin foil 52 which thus wraps around the tip of the second section 22 in a manner comparable to deep drawing. Hence, a thermocouple 10 as illustrated in Figure 3 results from step (B) of Figure 4. Additionally heat curing may be applied to intensify the bonding of the second material 42 to the first layer 31 of the first material 41.

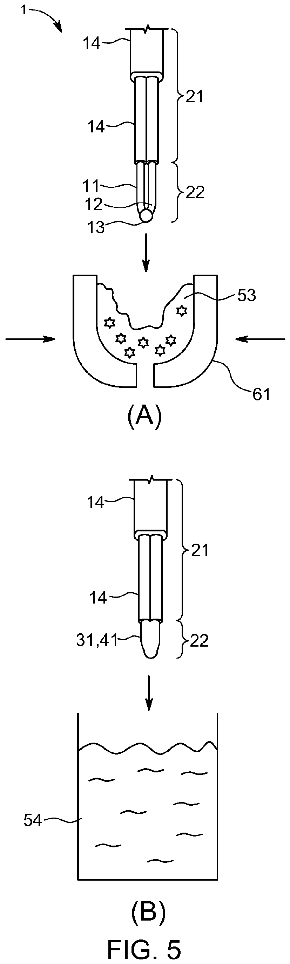

Figure 5 schematically illustrates another method for producing a thermocouple 10 of the invention. Therein, in step (A) a basic thermocouple 1 as described above is provided. In the first step (A) of the illustrated method, a grounded magnesium oxide powder 53 is provided into a compression mold 61. Preferably, the magnesium oxide powder 53 is mainly applied to the walls of the mold 61. As indicated by the single arrow in Figure 5 (A), the second section 22 of the basic thermocouple 1 is inserted into the mold 61 such that it is uniformly surrounded by the powder 53 attached to the walls of the mold 61. As indicated by the pair of arrows in Figure 5 (A), the mold 61 is then closed such that pressure is exerted on the magnesium oxide powder 53. The powder 53 is thus compacted and solidified around the second section 22 of the basic thermocouple 1. A first layer 31 of magnesium oxide as second material 41 is thus formed around the second section 22.

Subsequently, in the step (B) of the method illustrated in Figure 5, the tip of the second section 22 coated with the first layer 31 is immersed in an aluminum melt 54 for dip coating a second layer 32 of aluminum as second material 42 on at least a part of the first layer 31. Hence, a thermocouple 10 as illustrated in Figure 3 is produced in the step (B) of Figure 5.

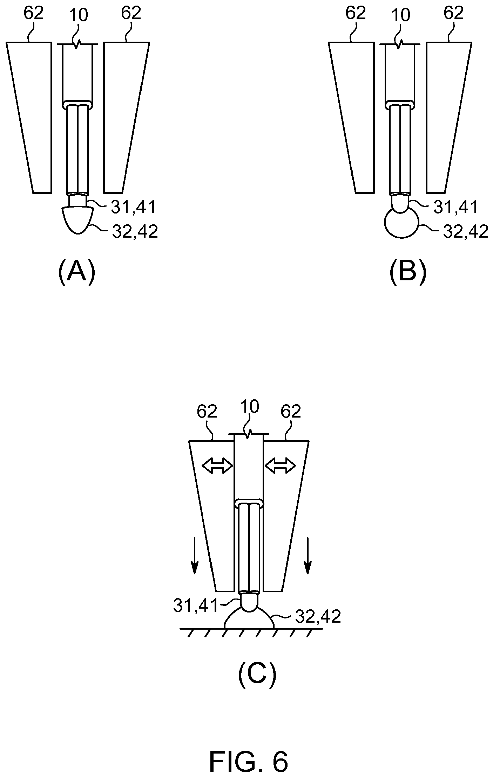

Figure 6 schematically illustrates the bonding of a thermocouple 10 according to an embodiment to a target surface 15 using a modified capillary tool 62. In a first step A of the illustrated method, a thermocouple 10 of the invention is loaded from a magazine (not shown) of a wire-bonding apparatus (not shown) hosting a plurality of such thermocouples 10 into a capillary tool 62 by at least one element for guiding and transporting the thermocouple 10. The capillary tool 62 comprises a capillary wherein the thermocouple is positioned and aligned such that the second section 22 of the thermocouple protrudes from an opening of the capillary tool 62. The capillary tool 62 is positioned above a target surface (not shown) at a position predetermined for establishing a weld connection between the thermocouple 10 and the target surface (not shown).

In a second step (B) of the method illustrated in Figure 6, heat is applied to the second section 22 of the thermocouple 10 by applying an electric arc (not shown) to the second section 22. This fuses at least parts of the second material 42 of the second layer 32 such that a ball of melted second material 42 forms at the tip of the second section 22.

In a third step (C) of the method illustrated in Figure 6, the thermocouple 10 is fixated in the capillary tool 62 by constricting at least a part of the capillary tool 62. The capillary tool 62 with the fixated thermocouple 10 is then lowered onto the target surface 15 as indicated by the downward facing arrows in Figure 6 (C). By further moving the capillary tool 62 towards the target surface 15 a downward pressure is exerted onto the second material 42. Simultaneously, ultrasonic energy is applied to the capillary tool 62 and the thermocouple 10 via an ultrasonic transducer (not shown) as indicated by the arrows facing sideways. By the combination of downward pressure and ultrasonic energy the at least partially fused second material 42 forms a weld connection with the target surface 15.

A thermocouple 10 of the invention as illustrated in Figure 3 an be produced from a standardized basic thermocouple 1 in a standardized method as schematically illustrated in Figures 4 and 5 and can be bonded to a target surface in a standardized bonding method using a common wire-bonding apparatus as illustrated in Figure 6. Hence, the welded mechanical connection between the second material 42 and the target surface 15 is well defined and highly replicable. Thus, a temperature measurement by the thermocouple 10 can obtain the temperature at the thermal interface of the welding area between the second material 42 and the target surface 15 in a highly reproducible and reliable manner.

Referring to Figure 8, an exemplary embodiment of a battery module 70 according to an embodiment includes a plurality of battery cells 71 aligned in one direction. Each battery cell 71 is a prismatic (or rectangular) cell, the wide flat surfaces of which are stacked together to form the battery module 70. Each battery cell 10 includes a battery case configured for accommodation of an electrode assembly and an electrolyte. The battery cells 71 are provided with positive and negative electrode terminals having different polarities. The positive and negative electrode terminals of neighboring battery cells 71 are electrically connected through busbars 74 such that a series connection of the battery cells 71 between a negative module terminal 72 and a positive module terminal 73 results. Hence, module 70 can be used as power source by connecting the plurality of battery cells 71 as one bundle.

In Figure 8, the battery module 70 and the cell supervision circuit, CSC, carrier 75 arranged on top of the battery cells 71 are illustrated in a top view. The CSC carrier 75 is arranged at a distance to the battery cells 71 and the busbars 74 and is positioned apart from the battery cells 71 by spacers (not shown). The CSC carrier 75 comprises three cell supervision circuits 78, which are microprocessors or ASICs that are configured to receive and process signals related to the temperature and the voltage of one or more battery cells 71. The CSC carrier 75 further comprises three pair of contact pads, each pair comprising a first contact pads 76 and a second contact pad 77 made of electroless nickel immersion gold (ENIG). The contact pads 76, 77 are connected to a respective one of the CSCs 78. Further, the busbars 74 are connected to the CSCs 78 via respective voltage sensing elements 79 in order to provide signals related to the voltages of the battery cells 71 to the CSCs 78.

The battery module 70 of Figure 8 further comprises three thermocouples 10 according to an embodiment. Therein, the second section (not shown) of each thermocouple 10 is welded to a top surface of a battery cell 71 via the second material 42 as described in more detail above. In this embodiment, first ends of the first and second wire (not shown) of the thermocouples 10 are connected in a measuring junction (not shown) embedded in the second material 42. The free second ends of the first and second wires are connected to a first contact pad 76 and a second contact pad 77, respectively. Therein, the bonds between the respective second ends of the wires and the contact pads 76, 77 have been established by the modified wire-bonding tool. Preferably, the bond between the respective second ends and the contact pads 76, 77 is one of a ball bond or a wedge bond.

Particularly, after producing the weld as illustrated in Figure 6, the thermocouple 10 is released in the capillary by reversing the constriction of the capillary tool 62. Then, the capillary tool 62 is moved towards the first contact pad 76 while the thermocouple 10 is guided through the capillary. At the position of the first contact pad 76, the free second end of the first wire is positioned in the opening of the capillary tool 62 and a ball- or wedge bond is produced between the second end of the first wire and the first contact pad 76 by fixating the first wire in the capillary tool 62 by constriction and by applying downward pressure and ultrasonic energy to the fixed first wire. After the first bond is produced, the constriction of the capillary tool 62 is reversed and the capillary tool is moved to the second contact pad 77, while the second wire of the thermocouple 10 is guided through the capillary. At the position of the second contact pad 77, the free end of the second wire is positioned in the opening of the capillary tool 62 and a ball- or wedge bond is produced between the second end of the second wire and the second contact pad 77 by fixating the second wire in the capillary tool 62 by constriction and by applying downward pressure and ultrasonic energy to the second wire. Therein, the second wire of the thermocouple 10is longer in length than its first wire.

The thermocouples 10 provide a temperate dependent voltage signal to the first and second contact pad 76, 77, respectively. From there, these signals are transmitted to a respective CSC 78 that determines a temperature at the contact area between the second material 42 of the respective thermocouple 10 and the respective battery cell 71 from a current related to a voltage difference between the second ends of the thermocouple's 10 first and second wire.

### Reference signs

- 1: basic thermocouple
- 10: thermocouple
- 11: first wire
- 12: second wire
- 13: measuring junction
- 14: plastic cable insulation
- 15: target surface

- 21: first section (of thermocouple)
- 22: second section (of thermocouple)
- 23: tip (of thermocouple)

- 31: first layer
- 32: second layer

- 41: first material
- 42: second material

- 51: melt or solution of the first material
- 52: thin foil of the second material
- 53: magnesium oxide powder
- 54: melt of the second material
- 61: mold
- 62: capillary tool

- 70: battery module
- 71: battery cell
- 72: negative module terminal
- 73: positive module terminal
- 74: busbar
- 75: cell supervision circuit carrier
- 76: first contact pad
- 77: second contact pad
- 78: cell supervision circuit
- 79: voltage sensing element

## Claims

1. Thermocouple (10) for temperature measurements, comprising:
a first wire (11) of a first metallic material and a second wire (12) of a second metallic material different from the first metallic material;
a first section (21) that is configured to bend elastically and wherein the first wire (11) and the second wire (12) run electrically isolated from each other;
a second section (22) wherein the first wire (11) and the second wire (12) are connected to each other to form a measuring junction (13);
a first layer (31) of a thermally conductive and electrically isolating first material (41) enclosing the second section (22); and
a second layer (32) of an ultrasonic-weldable second material (42) enclosing at least part of the first layer (31) and being configured to be ultrasonic welded to a target surface.

2. Thermocouple (10) of claim 1, wherein the first layer (31) and the second layer (32) are applied exclusively to the second section (22) and/or wherein, in the first section (21), at least one of the first wire (11) and the second wire (12) is enclosed by a plastic cable insulation (14).

3. Thermocouple (10) of claim 1, wherein a layer thickness of the first layer (31) is between 500 µm and 5 mm, and wherein a layer thickness of the second layer (32) is between 50 µm and 1 mm.

4. Thermocouple (10) of any one of the preceding claims, wherein the first material (41) is at least one of polyethylene, polyimide, polyamide, and magnesium oxide, and wherein the first material (41) preferably comprises a thermally conductive filler.

5. Thermocouple (10) of any one of the preceding claims, wherein the second material (42) comprises an alloy of at least one of gold, copper, and aluminum.

6. Thermocouple (10) of any one of the preceding claims, wherein the first wire (11) and the second wire (12) have different length.

7. Thermocouple (10) of any one of the preceding claims, wherein the first material (41) is at least one of polyethylene, polyimide, and polyamide, and wherein the the second section (22) is embedded in the first layer (31) of the first material (41) by immersing the second section (22) in a melt or solution (51) of the first material (41), and
wherein at least part of the first layer (31) is embedded in the second material (42) by wrapping a thin foil (52) of the second material (42) around a tip (23) of the second section (22).

8. Thermocouple (10) of claim 7, wherein the thin foil (52) of the second material (42) has a thickness between 50 µm and 1 mm and/or a surface area corresponding to the surface area of the second section (22) embedded in the first material (41).

9. Thermocouple of any one of claims 1 to 6, wherein the first material (41) is magnesium oxide, and wherein the second section (22) is embedded in the first layer (31) of the first material (41) by compression molding magnesium oxide powder (53) around the second section (22); and
wherein at least part of the first layer (31) is embedded in the second material (42) by immersing at least part of the second section (22) embedded in the first layer (31) in a melt (54) of an alloy of at least one of gold, copper, and aluminum as the second material (42).

10. Method for bonding a thermocouple (10) to a target surface (15), the methods comprising the steps of:
inserting at least one thermocouple (10) according to any one of the claims 1 to 9 into a magazine of a wire-bonding apparatus;
loading one thermocouple (10) from the magazine into a capillary tool (62) of the wire-bonding apparatus;
applying downward pressure and ultrasonic energy to the embedded second section (22) of the thermocouple (10) via the capillary tool (62); and
welding the second material (42) of the embedded second section (22) to the target surface (15).

11. Method according to claim 10, further comprising the step of at least partially fusing the second material (42) of the embedded second section (22) by applying heat or an electric arc thereto before applying downward pressure and ultrasonic energy thereto.

12. Use of a modified wire-bonding apparatus for bonding a thermocouple (10) according to any one of the claims 1 to 9 to a target surface (15), wherein the modified wire-bonding apparatus comprises a magazine configured for accommodating at least one thermocouple (10), and a capillary tool (62) configured for loading a thermocouple (10) and for applying downward pressure and ultrasonic energy to the embedded second section (22) of the loaded thermocouple (10), wherein an inner diameter of the capillary tool (62) is adapted to an outer diameter of the thermocouple (10).

13. Battery module (70), comprising
a plurality of stacked battery cells (71) electrically interconnected in series and/or in parallel between a negative module terminal (72) and a positive module terminal (73) via a plurality of busbars (74),
a cell supervision circuit carrier (75) arranged on top of the plurality of stacked battery cells (71) and comprising at least one first contact pad (76) and at least one second contact pad (77),
at least one thermocouple (10) according to any one of the claims 1 to 9, wherein the second material (42) of the embedded second section (22) of one of the at least one thermocouple (10) is welded to a top surface (15) of a battery cell (71) in a method according to claim 10 or 11, and wherein a free end of the first wire (11) is welded to the first contact pad (76) and a free end of the second wire (12) is welded to the second contact pad (77).

## Patentansprüche

1. Thermoelement (10) für Temperaturmessungen, das Folgendes umfasst:
einen ersten Draht (11) aus einem ersten metallischen Material und einen zweiten Draht (12) aus einem zweiten metallischen Material, das sich von dem ersten metallischen Material unterscheidet;
einen ersten Abschnitt (21), der dafür konfiguriert ist, sich elastisch zu biegen, und wobei der erste Draht (11) und der zweite Draht (12) elektrisch isoliert voneinander verlaufen;
einen zweiten Abschnitt (22), in dem der erste Draht (11) und der zweite Draht (12) miteinander verbunden sind, um eine Messstelle (13) zu bilden;
eine erste Schicht (31) aus einem wärmeleitfähigen und elektrisch isolierenden ersten Material (41), die den zweiten Abschnitt (22) umschließt; und
eine zweite Schicht (32) aus einem ultraschallschweißbaren zweiten Material (42), die mindestens einen Teil der ersten Schicht (31) umschließt und dafür konfiguriert ist, mit einer Zieloberfläche ultraschallverschweißt zu werden.

2. Thermoelement (10) nach Anspruch 1, wobei die erste Schicht (31) und die zweite Schicht (32) ausschließlich auf den zweiten Abschnitt (22) aufgebracht sind und/oder wobei in dem ersten Abschnitt (21) mindestens einer des ersten Drahtes (11) und des zweiten Drahtes (12) von einer Kunststoff-Kabelisolierung (14) umgeben ist.

3. Thermoelement (10) nach Anspruch 1, wobei eine Schichtdicke der ersten Schicht (31) zwischen 500 µm und 5 mm liegt, und wobei eine Schichtdicke der zweiten Schicht (32) zwischen 50 µm und 1 mm liegt.

4. Thermoelement (10) nach einem der vorangehenden Ansprüche, wobei das erste Material (41) mindestens eines von Polyethylen, Polyimid, Polyamid und Magnesiumoxid ist, und wobei das erste Material (41) bevorzugt ein wärmeleitfähiges Füllmaterial umfasst.

5. Thermoelement (10) nach einem der vorangehenden Ansprüche, wobei das zweite Material (42) eine Legierung aus mindestens einem von Gold, Kupfer und Aluminium umfasst.

6. Thermoelement (10) nach einem der vorangehenden Ansprüche, wobei der erste Draht (11) und der zweite Draht (12) eine unterschiedliche Länge aufweisen.

7. Thermoelement (10) nach einem der vorangehenden Ansprüche, wobei das erste Material (41) mindestens eines von Polyethylen, Polyimid und Polyamid ist, und wobei der zweite Abschnitt (22) in die erste Schicht (31) des ersten Materials (41) eingebettet wird, indem der zweite Abschnitt (22) in eine Schmelze oder Lösung (51) des ersten Materials (41) getaucht wird, und
wobei mindestens ein Teil der ersten Schicht (31) in das zweite Material (42) eingebettet wird, indem eine dünne Folie (52) des zweiten Materials (42) um eine Spitze (23) des zweiten Abschnitts (22) gewickelt wird.

8. Thermoelement (10) nach Anspruch 7, wobei die dünne Folie (52) des zweiten Materials (42) eine Dicke zwischen 50 µm und 1 mm und/oder eine Oberfläche aufweist, die der Oberfläche des in das erste Material (41) eingebetteten zweiten Abschnitts (22) entspricht.

9. Thermoelement nach einem der Ansprüche 1 bis 6, wobei das erste Material (41) Magnesiumoxid ist, und wobei der zweite Abschnitt (22) durch Formpressen von Magnesiumoxidpulver (53) um den zweiten Abschnitt (22) herum in die erste Schicht (31) des ersten Materials (41) eingebettet wird; und
wobei mindestens ein Teil der ersten Schicht (31) in das zweite Material (42) eingebettet wird, indem mindestens ein Teil des in die erste Schicht (31) eingebetteten zweiten Abschnitts (22) in eine Schmelze (54) einer Legierung aus mindestens einem von Gold, Kupfer und Aluminium als das zweite Material (42) getaucht wird.

10. Verfahren zum Bonden eines Thermoelements (10) an eine Zieloberfläche (15), wobei das Verfahren die folgenden Schritte umfasst:
Einsetzen mindestens eines Thermoelements (10) nach einem der Ansprüche 1 bis 9 in ein Magazin einer Drahtbondungsvorrichtung;
Laden eines Thermoelements (10) aus dem Magazin in ein Kapillarwerkzeug (62) der Drahtbondungsvorrichtung;
Anwenden eines abwärts gerichteten Drucks und von Ultraschallenergie an den eingebetteten zweiten Abschnitt (22) des Thermoelements (10) mittels des Kapillarwerkzeugs (62); und
Schweißen des zweiten Materials (42) des eingebetteten zweiten Abschnitts (22) an die Zieloberfläche (15).

11. Verfahren nach Anspruch 10, das des Weiteren den Schritt umfasst, das zweite Material (42) des eingebetteten zweiten Abschnitts (22) mindestens teilweise zu verschmelzen, indem Wärme oder ein elektrischer Lichtbogen daran angelegt wird, bevor ein abwärts gerichteter Druck und Ultraschallenergie daran angelegt werden.

12. Verwendung einer modifizierten Drahtbondungsvorrichtung zum Bonden eines Thermoelements (10) nach einem der Ansprüche 1 bis 9 an eine Zieloberfläche (15), wobei die modifizierte Drahtbondungsvorrichtung ein Magazin umfasst, das zur Aufnahme mindestens eines Thermoelements (10) konfiguriert ist, und ein Kapillarwerkzeug (62) umfasst, das zum Laden eines Thermoelements (10) und zum Anwenden von abwärts gerichtetem Druck und Ultraschallenergie an den eingebetteten zweiten Abschnitt (22) des geladenen Thermoelements (10) konfiguriert ist, wobei ein Innendurchmesser des Kapillarwerkzeugs (62) an einen Außendurchmesser des Thermoelements (10) angepasst ist.

13. Batteriemodul (70), das Folgendes umfasst:
mehrere gestapelte Batteriezellen (71), die über mehrere Sammelschienen (74) elektrisch zwischen einem negativen Modulanschluss (72) und einem positiven Modulanschluss (73) miteinander in Reihe und/oder parallel geschaltet sind,
einen Zellenüberwachungsschaltungsträger (75), der auf der Oberseite der mehreren gestapelten Batteriezellen (71) angeordnet ist und mindestens ein erstes Kontaktpad (76) und mindestens ein zweites Kontaktpad (77) umfasst, mindestens ein Thermoelement (10) nach einem der Ansprüche 1 bis 9, wobei das zweite Material (42) des eingebetteten zweiten Abschnitts (22) von einem des mindestens einen Thermoelements (10) in einem Verfahren nach Anspruch 10 oder 11 an eine Oberseite (15) einer Batteriezelle (71) geschweißt wird, und wobei ein freies Ende des ersten Drahtes (11) an das erste Kontaktpad (76) geschweißt wird und ein freies Ende des zweiten Drahtes (12) an das zweite Kontaktpad (77) geschweißt wird.

## Revendications

1. Thermocouple (10) pour mesures de température, comprenant :
un premier fil (11) en un premier matériau métallique et un deuxième fil (12) en un deuxième matériau métallique différent du premier matériau métallique ;
une première section (21) qui est configurée pour plier élastiquement et dans laquelle le premier fil (11) et le deuxième fil (12) sont isolés électriquement l'un de l'autre ;
une deuxième section (22) dans laquelle le premier fil (11) et le deuxième fil (12) sont connectés l'un à l'autre pour former une jonction de mesure (13) ;
une première couche (31) en un premier matériau thermiquement conducteur et électriquement isolant (41) renfermant la deuxième section (22) ; et
une deuxième couche (32) en un deuxième matériau soudable aux ultrasons (42) renfermant au moins une partie de la première couche (31) et étant configurée pour être soudée aux ultrasons sur une surface cible.

2. Thermocouple (10) selon la revendication 1, dans lequel la première couche (31) et la deuxième couche (32) sont appliquées exclusivement à la deuxième section (22) et/ou dans lequel, dans la première section (21), au moins l'un parmi le premier fil (11) et le deuxième fil (12) est renfermé par une isolation de câble plastique (14).

3. Thermocouple (10) selon la revendication 1, dans lequel l'épaisseur de couche de la première couche (31) est comprise entre 500 µm et 5 mm, et dans lequel l'épaisseur de couche de la deuxième couche (32) est comprise entre 50 µm et 1 mm.

4. Thermocouple (10) selon l'une quelconque des revendications précédentes, dans lequel le premier matériau (41) est au moins l'un parmi le polyéthylène, le polyimide, le polyamide et l'oxyde de magnésium, et dans lequel le premier matériau (41) comprend de préférence une charge thermiquement conductrice.

5. Thermocouple (10) selon l'une quelconque des revendications précédentes, dans lequel le deuxième matériau (42) comprend un alliage d'au moins l'un parmi l'or, le cuivre et l'aluminium.

6. Thermocouple (10) selon l'une quelconque des revendications précédentes, dans lequel le premier fil (11) et le deuxième fil (12) ont des longueurs différentes.

7. Thermocouple (10) selon l'une quelconque des revendications précédentes, dans lequel le premier matériau (41) est au moins l'un parmi le polyéthylène, le polyimide et le polyamide, et dans lequel la deuxième section (22) est encastrée dans la première couche (31) du premier matériau (41) par immersion de la deuxième section (22) dans une masse fondue ou une solution (51) du premier matériau (41), et
dans lequel au moins une partie de la première couche (31) est encastrée dans le deuxième matériau (42) par enroulement d'une feuille mince (52) du deuxième matériau (42) autour d'une pointe (23) de la deuxième section (22).

8. Thermocouple (10) selon la revendication 7, dans lequel la feuille mince (52) du deuxième matériau (42) a une épaisseur comprise entre 50 µm et 1 mm et/ou une superficie correspondant à la superficie de la deuxième section (22) encastrée dans le premier matériau (41).

9. Thermocouple selon l'une quelconque des revendications 1 à 6, dans lequel le premier matériau (41) est l'oxyde de magnésium, et dans lequel la deuxième section (22) est encastrée dans la première couche (31) du premier matériau (41) par moulage par compression de poudre d'oxyde de magnésium (53) autour de la deuxième section (22) ; et
dans lequel au moins une partie de la première couche (31) est encastrée dans le deuxième matériau (42) par immersion d'au moins une partie de la deuxième section (22) encastrée dans la première couche (31) dans une masse fondue (54) d'un alliage d'au moins l'un parmi l'or, le cuivre et l'aluminium en tant que deuxième matériau (42).

10. Procédé pour coller un thermocouple (10) à une surface cible (15), le procédé comprenant les étapes consistant à :
insérer au moins un thermocouple (10) selon l'une quelconque des revendications 1 à 9 dans un chargeur d'un dispositif de collage de fil ;
charger un thermocouple (10) depuis le chargeur dans un outil capillaire (62) du dispositif de collage de fil ;
appliquer une pression vers le bas et une énergie ultrasonique à la deuxième section encastrée (22) du thermocouple (10) via l'outil capillaire (62) ; et
souder le deuxième matériau (42) de la deuxième section encastrée (22) à la surface cible (15).

11. Procédé selon la revendication 10, comprenant en outre l'étape consistant à fondre au moins partiellement le deuxième matériau (42) de la deuxième section encastrée (22) en appliquant de la chaleur ou un arc électrique à celle-ci avant l'application d'une pression vers le bas et d'une énergie ultrasonique à celle-ci.

12. Utilisation d'un dispositif de collage de fil modifié pour coller un thermocouple (10) selon l'une quelconque des revendications 1 à 9 à une surface cible (15), dans laquelle le dispositif de collage de fil modifié comprend un chargeur configuré pour loger au moins un thermocouple (10), et un outil capillaire (62) configuré pour charger un thermocouple (10) et pour appliquer une pression vers le bas et une énergie ultrasonique à la deuxième section encastrée (22) du thermocouple chargé (10), où le diamètre intérieur de l'outil capillaire (62) est adapté au diamètre extérieur du thermocouple (10).

13. Module de batterie (70) comprenant
une pluralité d'éléments de batterie empilés (71) interconnectés électriquement en série et/ou en parallèle entre une borne de module négatif (72) et une borne de module positif (73) via une pluralité de barres omnibus (74),
un support de circuit de supervision d'élément (75) disposé au-dessus de la pluralité d'élément de batterie empilés (71) et comprenant au moins un premier plot de connexion (76) et au moins un deuxième plot de connexion (77),
au moins un thermocouple (10) selon l'une quelconque des revendications 1 à 9, dans lequel le deuxième matériau (42) de la deuxième section encastrée (22) de l'au moins un thermocouple (10) est soudé à une surface supérieure (15) d'un élément de batterie (71) dans un procédé selon la revendication 10 ou 11, et dans lequel une extrémité libre du premier fil (11) est soudé au premier plot de connexion (76) et une extrémité libre du deuxième fil (12) est soudé au deuxième plot de connexion (77).
